Europäisches Patentamt

European Patent Office

Office européen des brevets

(11) Numéro de publication : **0 433 174 B1**

(12) **FASCICULE DE BREVET EUROPEEN**

(19)

⑪

---

(45) Date de publication du fascicule du brevet :
**03.06.92 Bulletin 92/23**

(21) Numéro de dépôt : **90403570.6**

(22) Date de dépôt : **13.12.90**

(51) Int. Cl.$^5$ : **H01L 23/552,** H01L 29/788

---

(54) **Circuit intégré entièrement protégé des rayons ultra-violets.**

---

(30) Priorité : **15.12.89 FR 8916649**

(43) Date de publication de la demande :
**19.06.91 Bulletin 91/25**

(45) Mention de la délivrance du brevet :
**03.06.92 Bulletin 92/23**

(84) Etats contractants désignés :
**DE FR GB IT**

(56) Documents cités :
**EP-A- 0 044 384**
**EP-A- 0 227 549**
**US-A- 4 519 050**
**PATENT ABSTRACTS OF JAPAN, vol. 8, no. 88**
**(E-240)[1525], 21 avril 1984 & JP-A-59 6581**

(73) Titulaire : **SGS-THOMSON**
**MICROELECTRONICS S.A.**
**7, Avenue Galliéni**
**F-94250 Gentilly (FR)**

(72) Inventeur : **Edme, Franck**
**Cabinet Ballot-Schmit, 7, Rue Le Sueur**
**F-75116 Paris (FR)**
Inventeur : **Adjemian, Olivier**
**Cabinet Ballot-Schmit, 7, Rue Le Sueur**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

## Description

La présente invention a pour objet un circuit intégré protégé des rayons ultra-violets. Elle s'applique aux circuits intégrés réalisés en technologie MOS et en particulier aux circuits intégrés comprenant des cellules mémoires à grille flottante.

Il est courant d'utiliser des cellules mémoires à grille flottante pour particulariser un circuit intégré en sortie de fabrication, après les séquences de test: entre autres utilisations, pour fixer les divers chemins d'accès, autoriser ou non la lecture de zones mémoires. Ces cellules mémoires sont alors utilisées comme des fusibles. Elles sont bien sûr utilisées aussi, classiquement, dans des zones mémoires de circuit intégré.

Ces cellules mémoires à grille flottante sont sensibles aux rayons ultra-violets, qui provoquent le déstockage des charges de la grille flottante. Or tout utilisateur peut soumettre un circuit aux rayons ultra-violets. Il est donc important, dans certaines applications, de protéger le circuit des rayons ultra-violets, comme par exemple, dans les applications demandant une haute sécurité quant au maintien des informations dans une mémoire. Ainsi, il est nécessaire de garantir à certains utilisateurs une immunité totale aux rayons ultra-violets pendant plusieurs années.

De manière connue, on place alors un masque de métal, de l'aluminium par exemple, sur le circuit intégré. Ainsi sont par exemple réalisées des cellules dites UUPROM (Ultra-violet Unerasable PRogrammable Memory), à partir des cellules EPROM. L'expérience montre que ces cellules offrent une protection aux rayons ultra-violets limitée dans le temps.

En effet, dans un premier exemple de réalisation, cette protection n'est que de quelques semaines. Ceci n'est pas suffisant pour certaines applications.

Dans cet exemple, on a placé sur la cellule, dans un plan horizontal, un masque de métal qui isole des rayons ultra-violets, l'élément de la cellule à protéger, à savoir la grille flottante. Comme il n'y a cependant pas de protection entre le plan du substrat et celui du masque de métal, des rayons ultra-violets peuvent atteindre la grille flottante indirectement, par réflexion entre le substrat et le plan de métal, déstockant ainsi les charges qui y sont accumulées: l'immunité aux rayons ultra-violets ne dépasse pas quelques semaines.

Pour obvier à ce manque d'efficacité, dans un deuxième exemple de réalisation, on a fait des retombées de métal verticales du plan de métal. Ces retombées sont ancrées sur le substrat autour de la cellule à protéger. En fait, ces retombées de métal sont ancrées sur des diffusions de même type mais plus dopées en impuretés que celui du substrat. Ce sont des diffusions de prise de contact, par exemple $P^+$ réalisées dans un substrat P.

Une cellule mémoire à grille flottante doit cependant avoir sa source, son drain et sa grille de contrôle connectées à des lignes conductrices transportant les signaux de commande permettant de lire, de programmer ou d'effacer cette cellule. Si on isole cette cellule avec les retombées de métal ancrées sur une diffusion $P^+$ de prise de contact, il faut cependant pouvoir faire ces connexions aux lignes conductrices. On peut le faire pour la source ou le drain, qui dans l'exemple pris d'un substrat P, sont réalisés par des diffusions $N^+$. Il suffit de faire un caisson N à l'intérieur duquel on va réaliser la diffusion de prise de contact $P^+$ pour ancrer les retombées de métal Rm. Et à cheval sur le substrat et le caisson, on réalise deux diffusions $N^+$: l'une qui sera par exemple la source de la cellule, l'autre qui permettra par exemple le contactage en métal d'une ligne conductrice. La réalisation d'un tel caisson N est en effet nécessaire, car on ne peut technologiquement réaliser directement une diffusion $P^+$ dans une diffusion $N^+$, à cause de leurs taux d'impuretés respectifs.

C'est la connexion de la grille de contrôle qui est réalisée par une région en poly-silicium qui pose problème. En effet, la région en poly-silicium, qui matérialise la grille de contrôle, est au dessus du plan du substrat, mais en dessous de la plaque de métal. Elle empêche à son endroit une retombée verticale telle que décrite. En effet, il n'est pas possible de couper la grille de poly-silicium, ni de contacter la grille de contrôle à la plaque de métal qui est reliée à un potentiel: la grille de contrôle serait court-circuitée. En pratique, il n'y a pas de retombées de métal au niveau de la connexion entre la grille de contrôle et l'extérieur. La cellule n'est pas entièrement isolée.

On a donc, dans cet exemple, certes réduit les entrées possibles pour les rayons ultra-violets, mais ceux-ci peuvent toujours passer, via la grille de contrôle en poly-silicium. Et ces rayons, par réflexion entre le plan de métal et le substrat, peuvent atteindre la grille flottante. La durée d'immunité est ainsi augmentée à quelques mois. Pour des applications qui requièrent 4 à 5 années minimum d'immunité, le résultat n'est pas satisfaisant.

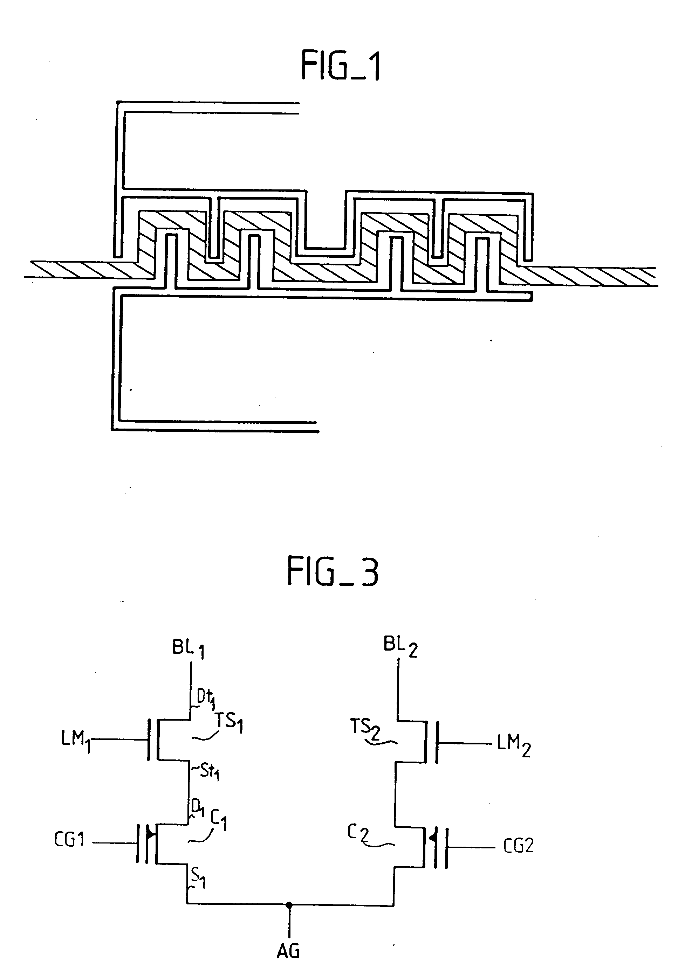

Dans un troisième exemple de réalisation, on a alors modifié le tracé de la grille de contrôle en poly-silicium, de manière à atténuer le taux de réflexion des rayons ultra-violets. Un tel exemple de réalisation est présenté sur la figure 1. Dans cette vue de dessus du circuit, on distingue deux lignes de métal, qui représentent l'impact sur le substrat des retombées verticales de métal. Ces lignes sont matérialisées, sur la figure 1, par une zone délimitée en traits gras.

On distingue aussi une ligne de poly-silicium, hachurée sur la figure, qui traverse, sans y être contactée,

2

les deux lignes de métal. Du côté intérieur de la zone protégée, la ligne de poly-silicium fait plusieurs virages à 90 degrés, le long d'un axe directeur. Les deux lignes de métal suivent, de chaque côté, le parcours sinueux de la ligne de poly-silicium. Par ces zigzags de métal et de poly-silicium enchevêtrés, les réflexions des rayons ultra-violets sont fortement atténuées et on obtient ainsi plusieurs années d'immunité aux rayons ultra-violets.

Cependant, ceci se fait au détriment de la surface occupée par la cellule; en effet, ces zigzags le long d'un axe directeur coûtent beaucoup de place. Et ils en coûtent d'autant plus que la durée d'immunité recherchée est grande. Ainsi, dans l'état actuel de la technique, on obtient une immunité de 4 ans pour une longueur, sur l'axe directeur des zigzags, de l'ordre de 200 $\mu$m. Sachant que pour ce même état de la technique, la cellule EPROM occupe normalement une surface de l'ordre de 180 $\mu$m$^2$, on voit que cette augmentation de surface est un inconvénient majeur en pratique, car on cherche toujours à diminuer les surfaces en vue d'une toujours plus grande densité d'intégration. De plus, ce rajout de matières entraîne un surcoût de fabrication.

L'invention a pour objet de résoudre ces inconvénients, en proposant une structure de cellule différente, qui permet d'une part, de réaliser un anneau constitué de retombées de métal qui soit continu autour de la cellule et d'autre part, de diminuer considérablement la dimension surfacique de la cellule UUPROM ainsi obtenue.

La présente invention a donc pour objet un circuit intégré réalisé en technologie MOS à partir d'un semi-conducteur d'un premier type de dopage, comportant au moins une cellule mémoire à grille flottante ayant une source, un drain et une grille de contrôle et protégée des rayons ultra-violets par un masque de métal qui la recouvre sur une surface supérieure, ce masque ayant des points d'ancrage sur le substrat semi-conducteur réalisés par des retombées de métal du masque de métal, comme connu des documents US-A-4519050 et EP-A-0227549, caractérisé en ce que la grille de contrôle est réalisée par une diffusion du second type de dopage, et en ce que ces points d'ancrage forment un anneau de métal continu, ancré sur un anneau de diffusion de même type mais plus dopé que le substrat et plus large que l'anneau de métal, cet anneau isolant complètement des rayons ultra-violets la cellule mémoire à grille flottante dans une zone intérieure à l'anneau de métal, le drain, la source et la grille de contrôle étant connectés à l'extérieur de l'anneau de métal par des connexions enterrées.

Les caractéristiques et avantages d'un circuit selon l'invention sont donnés dans la description qui suit. Cette description est faite en référence aux figures annexées, à titre indicatif et nullement limitatif de l'invention. Dans ces figures:

– la figure 1 est une vue de dessus d'un croisement d'une ligne de silicium poly-cristallin et de deux lignes de métal dans l'état de la technique de protection aux rayons ultra-violets, déjà décrite précédemment,
– la figure 2 est une vue de dessus d'une partie d'un circuit protégée des rayons ultra-violets selon l'invention,
– la figure 3 est l'équivalent électronique de la fonction représentée en vue de dessus sur la figure 2,
– la figure 4a est une vue en coupe AA' de la figure 2,
– la figure 4b est une vue en coupe BB' de la figure 2,
– la figure 4c est une vue en coupe CC' de la figure 2,
– la figure 4d est une vue en coupe DD' de la figure 2.

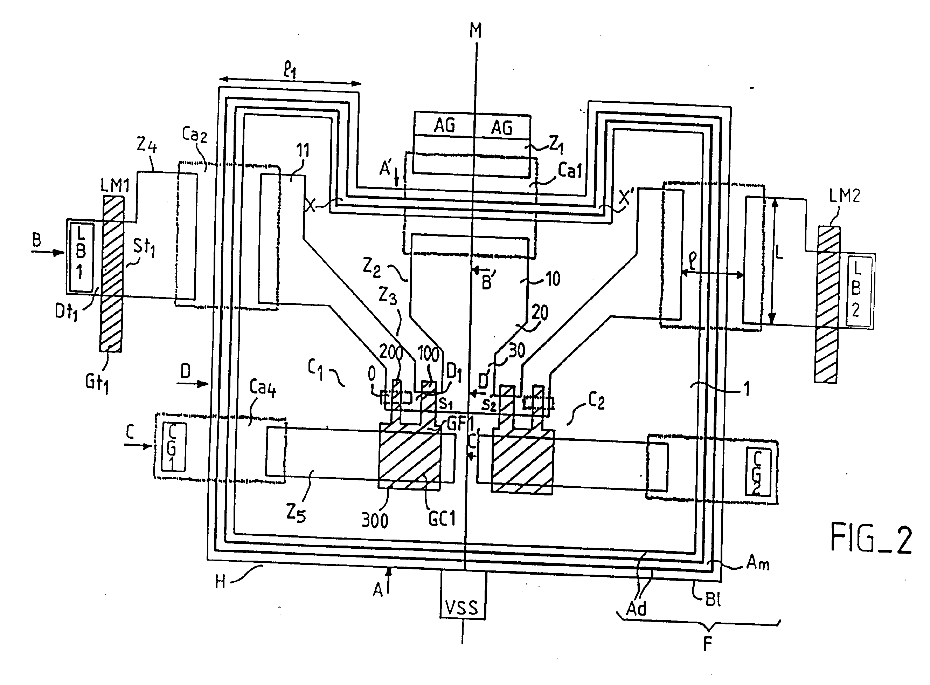

La figure 2 est une vue en plan de dessus d'une zone de circuit intégré protégée des rayons ultra-violets, selon un mode de réalisation de l'invention.

Dans ce mode de réalisation, deux cellules mémoires à grille flottante $C_1$ et $C_2$, de structures symétriques par rapport à un axe M, sont protégées des rayons ultra-violets dans une même zone intérieure 1. Cette zone intérieure 1 est délimitée dans le plan de la figure 2, par un anneau continu de métal Am délinéamenté en traits gras sur la figure 2. Dans le plan de cette figure, l'anneau Am est représenté par l'impact des retombées verticales de métal d'un masque de métal. Cet anneau de métal est limité en largeur par deux bordures extrêmes parallèles et en hauteur par le plan du substrat et le plan du masque de métal. Sa forme géométrique dans le plan de la figure 2 est définie comme suit:

– deux côtés parallèles, égaux et en vis à vis, encadrent verticalement la zone intérieure 1;
– un côté horizontal H réuni les deux côtés gauche et droit verticaux, par leurs extrémités basses;
– de l'extrémité haute du côté gauche vertical, un côté part perpendiculairement vers la droite sur une longueur $l_1$, puis effectue un virage à 90° vers le bas pour atteindre une extrémité X d'un segment XX' perpendiculaire et dirigé depuis l'extrémité X vers la droite;
– de l'extrémité haute du côté droit vertical, un côté part perpendiculairement vers la gauche sur une longueur $l_1$, puis effectue un virage à 90° vers le bas pour atteindre une extrémité X' du segment XX';
– l'axe de symétrie M est la médiatrice du segment XX'.

Dans le plan de la figure 2, la surface de l'anneau de métal Am est incluse entièrement dans la surface d'un anneau de diffusion Ad. Les deux bordures extrêmes qui délimitent la largeur de l'anneau de diffusion Ad sont parallèles aux bordures extrêmes de l'anneau Am qu'il contient: l'anneau Ad a la même forme que l'anneau Am qu'il contient. Par ailleurs, l'anneau Ad est bordé par une bordure limite Bl sur sa bordure extrême externe, sa bordure extrême interne délimitant la zone intérieure 1.

Dans la suite, on appelle frontière F, l'ensemble constitué des anneaux Am et Ad et de la bordure Bl. Et on prend par exemple un substrat de type P.

Sous la frontière, à l'endroit du segment XX', un caisson N Ca1 est délimité par un parallélogramme. La frontière F le traverse, parallèlement à deux côtés du parallélogramme, en vue de dessus.

Dans un exemple préféré, le parallélogramme du caisson Ca1 est un rectangle, les 2 côtés de la plus grande longueur étant parallèles à la frontière qui traverse le caisson Ca1. La médiatrice des côtés du caisson Ca1 parallèles à la frontière est confondue avec la médiatrice M du segment XX', qui est encore l'axe de symétrie M du circuit dans cet exemple de réalisation selon l'invention. Sur la figure 2, le caisson Ca1 est délimité par des traits frangés.

A cheval sur le substrat et une partie du caisson Ca1, à l'extérieur de la frontière, une zone Z1 diffusée N$^+$ est délimitée par un parallélogramme. Un contact de métal AG est réalisé sur toute une partie de l'extrémité externe à la frontière F de la zone diffusée Z1. AG est la masse commandée d'un plan mémoire non représenté contenant les cellules C$_1$ et C$_2$.

Dans l'exemple, ce parallélogramme est rectangulaire. Les deux côtés de la plus grande longueur de la diffusion Z1 sont parallèles à ceux de la plus grande longueur du caisson Ca1. Ils sont aussi moins longs; leur médiatrice est confondue avec l'axe M de symétrie.

A cheval sur le caisson Ca1 et sur le substrat côté zone intérieure 1, une partie 10 d'une zone diffusée N$^+$ Z2 est de même forme, d'égale et parallèle plus grande longueur que la zone diffusée Z1 en vis à vis. La zone diffusée Z2 est symétrique par rapport à l'axe M. La partie 10 se prolonge par un rétrécissement oblique 20 de symétrie M vers un nouveau parallélogramme 30 de symétrie M. Cette dernière partie 30 de la zone diffusée Z2 se continue par une zone diffusée N$^+$ qui s'étend, sur sa plus grande longueur, perpendiculairement à l'axe M et symétriquement de part et d'autre de celui-ci: à gauche de l'axe M, c'est la source S$_1$ de la cellule C$_1$; à droite, c'est la source S$_2$ de la cellule C$_2$.

En fait, cette disposition permet de relier la source S$_1$ et la source S$_2$ à la masse commandée AG par un seul lien conducteur matérialisé par la zone Z2, par le caisson Ca1, par la zone Z1, et enfin par le contact métal par lequel est transmis le signal de masse commandée AG (pour Array Ground, en littérature anglo-saxonne). Mais ce lien conducteur ainsi matérialisé est en fait la réunion de deux liens conducteurs, chacun des liens étant notamment de largeur suffisante pour l'appel de courant sur chacune des sources S$_1$ et S$_2$.

Dans la suite de la description, on s'intéresse au demi-plan gauche par rapport à l'axe M, qui contient la cellule C$_1$. La description s'applique de manière symétrique (symétrie M) au demi-plan droit qui contient la cellule C$_2$.

La cellule mémoire C$_1$ a une zone source S$_1$ et une zone drain D$_1$ qui sont des diffusions N$^+$, une grille flottante GF$_1$ réalisée sous forme d'une région en poly-silicium et une grille de contrôle GC$_1$ qui est une diffusion N$^+$ dans l'invention.

Si on part vers la gauche, à partir de la zone diffusée N$^+$ de la source S$_1$. Celle-ci est coupée perpendiculairement à sa plus grande longueur, soit verticalement, par une branche 100 rectangulaire de la grille flottante GF$_1$. L'axe de la plus grande longueur de la branche 100 est vertical. Alignée dans l'axe horizontal de la plus grande longueur de la zone S$_1$, à gauche de la branche 100, on a la zone diffusée N$^+$ du drain D$_1$ de la cellule C$_1$. A gauche de cette zone D$_1$, une autre branche 200 de la grille flottante GF$_1$ passe au-dessus de la zone D1 perpendiculairement à sa plus grande longueur (soit verticalement dans la description). La branche 200 a la même forme dans le plan de la figure 2 que la branche 100, mais elle est plus étroite. A l'extrémité haute de la branche 200, la zone de diffusion D$_1$ se continue en une autre zone de diffusion N$^+$ Z3, qui part verticalement vers le haut, puis rapidement en oblique gauche vers le haut de la zone intérieure 1. Cette zone Z3 se termine par un parallélogramme 11, de préférence rectangulaire. La diffusion Z3, dans cette partie 11 est réalisée à cheval sur le substrat de la zone intérieure et un caisson Ca2.

Le caisson Ca2 est de préférence rectangulaire; ses deux côtés de plus grande longueur sont parallèles à ceux du parallélogramme 11 de la zone Z3 en vis à vis et plus longs. Le caisson Ca2 est traversé par le côté gauche vertical de la frontière, parallèlement à ses deux côtés de plus grande longueur.

A l'extérieur de la frontière, à cheval sur le substrat et le caisson Ca2, une diffusion N+ Z4 est réalisée de même forme et d'égale plus grande longueur que la partie 11 de la diffusion Z3, qui est en vis à vis. Cette diffusion Z4 à une partie à gauche plus étroite qui forme aussi un parallélogramme et qui réalise la source St$_1$ du transistor de sélection TS$_1$. Cette partie diffusée St$_1$ est coupée à gauche et perpendiculairement par une région poly-silicium qui réalise la grille de commande Gt$_1$ du transistor de sélection et qui transporte un signal de ligne de mot LM$_1$.

Cette région en poly-silicium coupe à gauche et perpendiculairement la zone de diffusion de drain Dt$_1$ du transistor TS$_1$, zone Dt$_1$ qui est en vis à vis de celle de la source St$_1$. Sur cette zone de diffusion Dt$_1$, est réalisée

un contact métal. Ce contact métal transmet un signal de ligne de bit LB1 au drain $Dt_1$ du transistor de sélection $TS_1$.

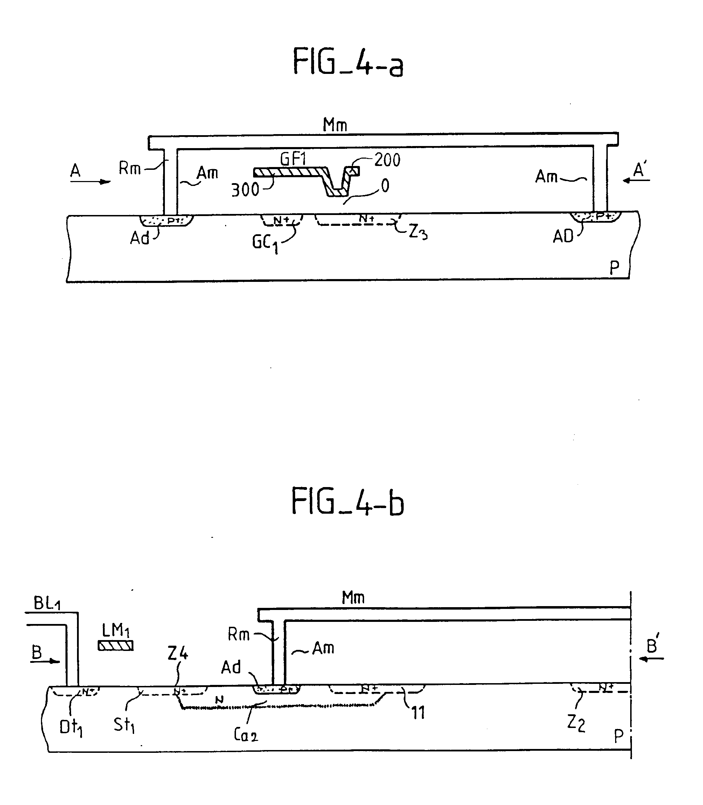

La zone de diffusion Z3, indirectement par le biais du caisson Ca2 et de la zone de diffusion Z4, contacte le drain D1 de la cellule $C_1$, à la source $St_1$ du transistor de sélection $TS_1$ (figure 3).

La zone $D_1$ se prolonge en effet comme on l'a vu par la zone de diffusion Z3.

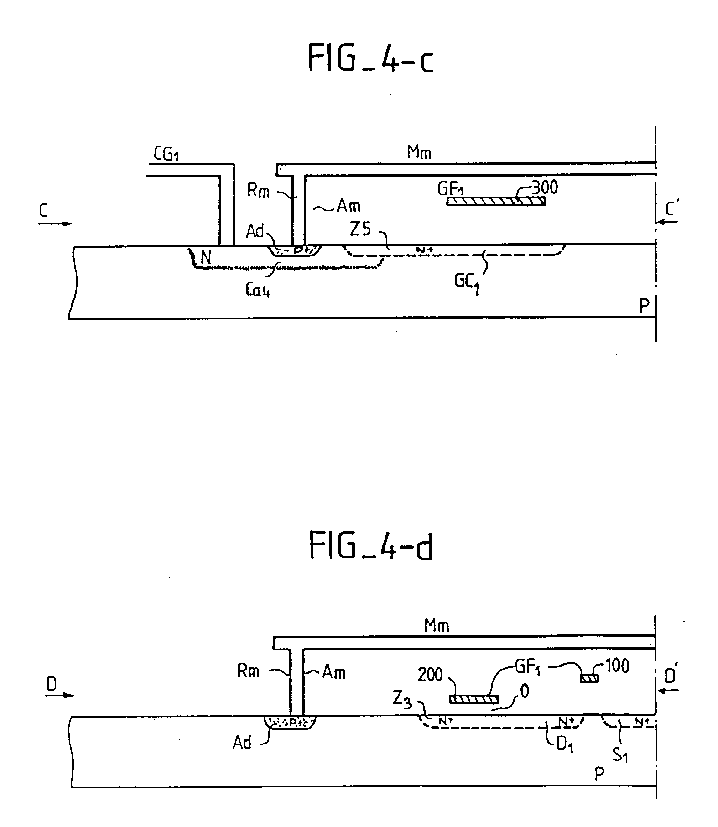

La branche 200 de la grille flottante $GF_1$ par ailleurs se rapproche à un endroit du substrat, diminuant ainsi l'épaisseur d'oxyde à cet endroit et notamment à proximité du drain $D_1$: cette région d'épaisseur d'oxyde plus faible (par exemple 9 mm (90 Angströms) est appelée région d'oxyde tunnel O (figures 4.d, 4.a)). Elle favorise le transfert de charges entre le drain D1 et la grille flottante $GF_1$.

Les deux branches 100 et 200 rejoignent en leur extrémité basse un parallélogramme 300 placé plus bas que les zones alignées de la source $S_1$ et du drain $D_1$ de la cellule $C_1$. Cette partie 300 de la grille $GF_1$ recouvre une diffusion N+ Z5 qui réalise sous cette grille flottante, la grille de controle $GC_1$. La diffusion Z5 se prolonge vers la gauche, vers la frontière où elle se termine à cheval sur le substrat de la zone intérieure 1 et un caisson N Ca4 réalisé de part et d'autre et sous la frontière, comme les caissons $Ca_1$ et $Ca_2$ déjà vus. La frontière traverse le caisson $Ca_4$ parallèlement à un de ses côtés. Ce caisson $Ca_4$ est de préférence un parallélogramme. Ce sont les côtés les plus courts qui sont, cette fois, ceux parallèles à la frontière. Sur une partie du caisson du côté extérieur à la frontière, un contact métal est réalisé. Il transporte un signal de commande de grille $CG_1$ de la grille de contrôle $GC_1$ de la cellule $C_1$.

Les signaux AG, LB1, LM1 et CG1 sont les 4 signaux de commande associés au transistor de sélection $TS_1$, et à la cellule mémoire $C_1$; par leur état, ils commandent une lecture, une programmation ou un effacement de la cellule $C_1$. Un exemple des états correspondant à une lecture, une programmation ou un effacement sont donnés dans le tableau suivant:

|  | CG1 | LM1 | LB1 | AG |
|---|---|---|---|---|
| Programmation | Vss | 20v | 20v | en l'air |
| Effacement | 20v | 20v | en l'air | VSS |
| Lecture | 2v | 5v | vers le circuit de lecture | Vss |

Vss est la masse électrique du circuit à laquelle est relié le masque de métal et donc également l'anneau de diffusion Ad.

On a vu que l'anneau de diffusion de prise de contact Ad est avantageusement plus large que l'anneau Am qu'il contient entièrement. En effet, les retombées verticales sont par exemple obtenues, en creusant le circuit jusqu'au substrat, selon des procédés technologiques bien connus. Des trous sont alors formés, dont le fond est constitué par la surface du substrat. Il ne faut pas que la surface du substrat mise ainsi à nue soit plus large que la diffusion de prise de contact à fleur du substrat, car, sinon, le métal risque de se contacter, non seulement sur cette diffusion, mais aussi de part et d'autre de cette diffusion, avec les risques de court-circuit que cela entraîne.

A l'extérieur de l'anneau de diffusion de prise de contact, Ad, par rapport à la zone intérieure 1, la bordure limite Bl représente la projection des contours du masque de métal, dans le plan de la figure 2. Dans l'exemple décrit et comme on peut le voir sur les figures 4a à 4d, le masque de métal Mm déborde des retombées de métal Rm verticales. Ceci permet d'assurer de manière fiable que la couche de métal, quand elle va être appliquée, va bien remplir tous les trous jusqu'au fond, c'est à dire jusqu'à la surface du substrat. Puisque la couche de métal est étalée, il est en effet préférable d'avoir une surface plane de part et d'autre du trou.

La cellule mémoire $C_1$ a une grille flottante $GF_1$ et une grille de contrôle $GC_1$. Sa particularité essentielle utilisée dans l'invention, est que sa grille de contrôle est une diffusion et non pas une grille de poly-silicium comme pour les cellules UUPROM dans l'art antérieur. En effet, une cellule ayant sa grille de contrôle en diffusion et sa grille flottante en poly-silicium, est sensiblement plus large qu'une cellule à deux niveaux de poly-silicium (grille flottante et grille de contrôle). On a vu en effet que la grille de contrôle $GC_1$ en diffusion est déportée dans le plan, par rapport aux régions source $S_1$ et drain $D_1$, la grille flottante recouvrant alors les régions source et drain d'une part et la grille de contrôle d'autre part. Dans une cellule à deux niveaux de poly-silicium, la grille de contrôle recouvre la grille flottante, qui recouvre elle-même les régions source et drain. Une telle structure est donc plus dense que celle étalée de la cellule à un seul niveau de poly-silicium. Cette plus grande consommation de surface est d'ailleurs l'inconvénient majeur de cette technologie dite à un seul niveau de poly-silicium. Cependant, on montrera plus loin que pour la réalisation de cellule UUPROM, cet inconvénient majeur devient un avantage certain. De plus, la réduction à 1 seul niveau de poly-silicium élimine 1 niveau de masque: cette technique est moins coûteuse en masques.

Dans l'exemple, on a choisit de représenter une cellule de type EEPROM, et un mode possible de réalisation d'une telle cellule. Mais il est entendu que l'invention ne se limite pas à cet exemple d'un mode de réalisation ni à ce type de cellule. On aurait, par exemple, tout aussi bien pu représenter une cellule EPROM. La seule limitation est que la cellule comporte une grille flottante, élément susceptible d'être déchargé par des rayons ultra-violets.

Une cellule EEPROM est nécessairement commandée par un transistor de sélection, dès lors que l'on veut avoir au moins deux parmi les trois commandes que sont la lecture, la programmation et l'effacement de la cellule. Le schéma électrique correspondant à la figure 2 est donné en figure 3. Le transistor de sélection $TS_1$ et la cellule mémoire $C_1$ sont à canal de même type, opposé au type de dopage du substrat.

La description qui est faite avec un substrat P est facilement transposable à un substrat de type N, en inversant le type d'impuretés et la polarisation dans la description.

La cellule EEPROM est, dans l'exemple, non symétrique: le drain $D_1$ et la source $S_1$ ne sont pas interchangeables. Le drain $D_1$ est en effet particularisé par une région d'oxyde mince O, sous la branche 200 de la grille flottante GF1, qui facilite le transfert des charges par effet tunnel. C'est ce qui est représenté en coupe DD' sur la figure 4d, avec la zone d'oxyde tunnel O sous la branche 200 de la grille flottante $GF_1$.

La diffusion $N^+$ de la grille de contrôle $GC_1$, est réalisée avant la région poly-silicium 300, au dessus d'elle. La diffusion $N^+$ est alors bien présente sous la grille flottante, comme on peut le voir sur les coupes AA' et CC' des figures 4a et 4c respectivement.

Les deux paragraphes précédents décrivent une réalisation possible d'une cellule EEPROM $C_1$ à un seul niveau de poly-silicium, dans une zone intérieure 1. Cette structure de cellule permet que le passage de tous les signaux entre la zone intérieure 1 et l'extérieur de la frontière définie par les anneaux Am et Ad, se fasse tous en conduction par l'intermédiaire d'un caisson sous cette frontière. Ce sont des connexions enterrées, c'est à dire qui se font dans le substrat sous la frontière. Ainsi pour chacun des signaux listés ci-après, c'est ce type de connexion qui a été utilisé:

– la grille de contrôle $GC_1$, à relier à la commande de la grille $CG_1$: caisson Ca4;
– la source $S_1$ de la cellule $C_1$, à relier à la masse commandée AG: caisson Ca1;
– la diffusion Z3, connectée au drain $D_1$ de la cellule $C_1$, à relier à la source $St_1$ du transistor $TS_1$: caisson Ca2.

Prenons, par exemple, le caisson N Ca2. Après avoir réalisé ce caisson Ca2 (diffusion N dans le substrat P), on réalise dans ce caisson Ca2 la diffusion $P^+$ de l'anneau de prise de contact Ad (figure 2 et 4b): cette diffusion $P^+$ occupe donc toute la plus grande longueur du caisson en vue de dessus (figure 2). On réalise ensuite une diffusion $N^+$, de part et d'autre de la diffusion $P^+$ et à cheval sur le caisson Ca2 et le substrat P: dans l'exemple Z4, qui se prolonge par la source $St_1$ et Z3. La conduction se fait entre les deux zones de diffusion $N^+$, Z3 et Z4, via le caisson Ca2, sous l'anneau de prise de contact Ad et donc aussi sous l'anneau de métal Am. Une première zone de diffusion est donc dans la zone intérieure 1, Z3 dans l'exemple. Une seconde est à l'extérieur, Z4 dans l'exemple.

On peut dans certains cas ne pas réaliser cette seconde diffusion et réaliser directement un contact métal sur la diffusion N du caisson, à l'extérieur de la frontière. Dans l'exemple de la figure 2, c'est ainsi qu'est réalisé le contact métal associée à la commande de grille de contrôle $CG_1$. Cette deuxième réalisation possible est représentée en coupe sur la figure 4c. Tout dépend de la topologie de la circuiterie qui génère par exemple $CG_1$. Ainsi si le signal $CG_1$ est généré loin de la cellule UUPROM, il sera amené jusqu'à elle, par une ligne en métal: on réalisera alors directement le contact métal sur le caisson $Ca_4$ dans l'exemple. Par contre, si le signal $CG_1$ est issu d'un transistor tout proche de la cellule UUPROM, il arrivera en diffusion $N^+$ et un contact $N^+$, sur le caisson s'imposera: c'est le cas dans l'exemple du caisson $Ca_2$ pour le signal $St_1$. Ces contacts métal sont réalisés à l'extérieur de la frontière. S'ils étaient en effet réalisés à l'intérieur de la frontière, il faudrait faire traverser au conducteur métallique qui transporte un signal de commande, soit le masque de métal, soit les retombées Rm de ce masque de métal qui sont mis au potentiel de masse Vss: on provoquerait un court-circuit.

Les réalisations du caisson N et de la diffusion P$^+$ rajoutent deux opérations supplémentaires dans la réalisation de la cellule. Par contre, les masques correspondant existent et seul leur dessin est à modifier, de même que le dessin du masque des diffusions N$^+$ à réaliser.

C'est parce qu'il faut empêcher la conduction des différentes diodes PN, constituées par les jonctions:
– diffusion P$^+$ et caisson N,
– substrat P et caisson N, que l'on relie le masque de métal au plan de masse VSS du circuit. Ainsi, ces différentes diodes sont toujours polarisées en inverse et bloquées.

Par ailleurs, le rapport de la largeur l séparant deux diffusions N$^+$ de part et d'autre d'un caisson à la frontière, à la plus grande longueur L de ces diffusions N$^+$ parallèles à la frontière, est rendu le plus petit possible, tout en respectant les règles de dessin, de manière à réduire au maximum la résistance induite R par le caisson N. En effet, la résistivité p du caisson N est plus forte que celle d'une diffusion N$^+$, car la résistivité d'une diffusion est inversement proportionnelle au taux de dopage. Or la résistance induite R a comme conséquence directe sur les signaux de commande, d'augmenter le temps d'accès de la cellule, alors que l'on cherche toujours à diminuer ce temps d'accès. On rappelle que la valeur de cette résistance induite, R, est donnée par l'expression suivante

$$R = (l/L)xp$$

Selon l'invention, on choisit de préférence un rapport l/L optimum pour une résistance induite minimum. En particulier, c'est dans cet esprit que sont réalisées dans l'exemple les diffusions pour les connexions enterrées liées au signal AG et à la source St$_1$ du transistor de sélection.

On a vu précédemment comment la diffusion de prise de contact P$^+$ de l'anneau Ad est réalisée dans un caisson N. En dehors des caissons réalisés pour assurer la conduction des signaux de commande, la diffusion P$^+$ est directement réalisée dans le substrat P, comme on le voit par exemple en coupe AA', sur la figure 4a et en coupe DD' sur la figure 4d.

C'est ainsi que l'on peut donc ancrer en continu des retombées de métal sur une diffusion P$^+$, cette diffusion étant tantôt réalisée dans le substrat P, tantôt réalisée dans un caisson N pour assurer la conduction des signaux de commande à l'intérieur de la frontière.

On peut ainsi protéger totalement des rayons ultra-violets toute cellule, ou tout ensemble de cellules qui, dans un certain périmètre, a tous ses signaux de commande en diffusion: l'anneau de prise de contact Ad et les retombées verticales de métal ancrées sur l'anneau Ad seront faites sur ce périmètre.

Dans le cas d'une cellule EEPROM qui est commandée par un transistor de sélection TS$_1$, on place de préférence ce transistor de sélection TS$_1$ à l'extérieur de ce périmètre car sa grille de commande est réalisée en poly-silicium. Ceci n'est pas gênant par ailleurs, car il n'est pas à protéger des rayons ultra-violets.

En effet, il serait techniquement possible de réaliser un contact métal à partir d'une ligne de métal au dessus de la grille de commande, entre cette grille de commande réalisée en poly-silicium et une diffusion N+, pour assurer la conduction entre ces deux parties. On pourrait aussi utiliser une technologie de "buried-contact" qui permet de connecter directement du poly-silicium à une diffusion ou au substrat. Mais cette dernière technologie est chère et difficile à réaliser. En utilisant de telles techniques on pourrait cependant inclure le transistor de sélection dans la zone intérieure 1, en réalisant une connexion entre cette diffusion N+et l'extérieur de la frontière.

Cette solution présente cependant de nombreux inconvénients. Tout d'abord, elle augmente le nombre de caissons nécessaires aux connexions entre la zone intérieure 1 et l'extérieur. En effet, si on place le transistor de sélection TS$_1$ à l'extérieur, seule sa source St$_1$ est à connecter dans la zone intérieure 1. En le plaçant à l'intérieur, non seulement la diffusion associée à la grille de commande, mais aussi celle du drain Dt$_1$ sont à connecter à l'extérieur. On a alors dans ce cas un caisson supplémentaire et donc, la surface finale occupée par la cellule protégée est plus grande. De plus, le transistor de sélection TS$_1$ a alors les deux signaux de lignes de commande LB$_1$ et LM$_1$, qui sont transmis par l'intermédiaire d'un caisson sous la frontière, ce qui dégrade le temps d'accès au transistor et donc à la cellule. Enfin le contact métal entre la grille de commande et une diffusion N$^+$ devrait se faire par une ligne de métal, située dans un plan au dessus de la grille de commande, cette ligne de métal ayant à ses deux extrémités deux retombées, une sur la grille, une sur la diffusion. Comme la ligne de métal ne pourrait être dans le plan du masque du métal, on aurait donc un deuxième plan de métal compris entre le premier plan de métal du masque de métal et la grille de commande. On aurait donc deux niveaux de métal et une augmentation du nombre de couches du circuit. De plus, en pratique, on ne veut qu'un seul niveau de métal dans un circuit intégré, à mémoire en particulier. Enfin la multiplicité des contacts et modes de conduction tend à augmenter le temps d'accès (conduction par l'intermédiaire d'un caisson, contact métal entre une diffusion N$^+$ et une région en poly-silicium).

On peut cependant remarquer que, selon cette technique, on pourrait réaliser la protection totale selon l'invention, d'une cellule à grille flottante ayant sa grille de contrôle en poly-silicium et contactée en métal à une diffusion N$^+$. Mais on a vu les inconvénients d'une telle technique de contact métal et on lui préférera la première technique de réalisation décrite. Ceci rend particulièrement intéressant le choix d'une cellule EEPROM dont la grille de contrôle est réalisée sous la forme d'une région en diffusion N+, située sous la grille flottante et d'un transistor de sélection placé à l'extérieur de la frontière. Dans ce cas, les lignes de métal évoquées ci-dessus deviennent inutiles.

Enfin, on notera que dans l'invention, il n'est pas important que les retombées de métal soient verticales: c'est une caractéristique qui découle seulement de l'exemple de procédé d'obtention de ces retombées décrit. Il faut seulement que ces retombées relient le masque de métal au substrat et qu'elles soient ancrées en continu sur une diffusion du substrat, de manière à isoler complètement la zone intérieure des rayons ultra-violets.

Dans l'exemple de la figure 2, on a deux cellules mémoire $C_1$ et $C_2$ dans la zone intérieure 1. On a ainsi une "double" cellule UUPROM.

L'utilisation d'une cellule à grille de contrôle diffusée a permis d'une part de protéger totalement des rayons ultra-violets une cellule mémoire à grille flottante, et ce de manière simple et dans le principe et surtout dans sa réalisation pratique, puisqu'il n'augmente pas le nombre de masques nécessaires. Il a permis d'autre part, et c'est un avantage considérable du point de vue densité d'intégration, de réduire considérablement la surface occupée par une telle cellule UUPROM. Dans l'exemple de la cellule double, on peut atteindre par exemple une surface de 242 $\mu m^2$. Par ailleurs, la technologie associée aux cellules à grille de contrôle en diffusion est plus simple et plus fiable que celle des cellules à deux niveaux de poly-silicium, à cause de l'absence d'inter-poly entre la grille flottante et la grille de contrôle. Ces avantages se répercutent donc sur la fiabilité de telles cellules UUPROM selon l'invention.

Les cellules $C_1$ et $C_2$ ont dans l'exemple, leur source $S_1$ et $S_2$ au même signal de masse commandée AG : ce signal est commun en fait à tout le plan mémoire et les cellules $C_1$ et $C_2$ sont indépendantes. D'autres configurations sont possibles, suivant la fonction logique à réaliser. Dans l'exemple, on a réduit la surface occupée par deux cellules mémoire protégées des rayons ultra-violets selon l'invention, de deux fois la surface d'une ligne d'anneau Ad selon l'axe M, par rapport à la surface occupée par deux cellules mémoire protégées chacune indépendamment des rayons ultra-violets selon l'invention. On pourrait aussi avoir une telle structure avec trois ou quatre cellules, en utilisant une symétrie par rapport au côté bas horizontal H.

Enfin, l'invention s'applique aussi à une cellule toute seule.

## Revendications

1. Circuit intégré réalisé en technologie MOS à partir d'un semi-conducteur d'un premier type de dopage (P), comportant au moins une cellule mémoire ($C_1$) à grille flottante ($GF_1$) ayant une source ($S_1$), un drain ($D_1$) et une grille de contrôle ($GC_1$) et protégée des rayons ultra-violets par un masque de métal (Mm) qui la recouvre sur une surface supérieure, ce masque ayant des points d'ancrage sur le substrat semi-conducteur réalisés par des retombées de métal (Rm) du masque de métal (Mm), caractérisé en ce que la grille de contrôle ($GC_1$) est réalisée par une diffusion du second type de dopage ($N^+$), et en ce que ces points d'ancrage forment un anneau de métal continu (Am), ancré sur un anneau de diffusion (Ad) de même type mais plus dopé ($P^+$) que le substrat (P) et plus large que l'anneau de métal (Am), cet anneau de métal isolant complètement des rayons ultra-violets la cellule mémoire à grille flottante ($C_1$), dans une zone intérieure (1) à l'anneau de métal (Am), le drain ($D_1$), la source ($S_1$) et la grille de contrôle ($GC_1$) étant connectés à l'extérieur de l'anneau de métal (Am) par des connexions enterrées.

2. Circuit intégré selon la revendication 1, caractérisé en ce que les retombées de métal (Rm) du masque de métal (Mm) ne sont pas réalisées au bord du masque de métal (Mm).

3. Circuit intégré selon la revendication 1 ou la revendication 2, caractérisé en ce qu'un circuit de sélection ($TS_1$) de la cellule UUPROM est placé en dehors de l'anneau de métal (Am).

4. Circuit selon l'une quelconque des revendications 2 ou 3, caractérisé en ce que deux cellules mémoire à grille flottante ($C_1$, $C_2$) sont à l'intérieur d'un même anneau de métal, ayant chacune leur transistor de sélection ($TS_1$, $TS_2$) et n'ayant comme lien commun entre elles que leurs sources ($S_1$, $S_2$) liées à un même signal de masse commandée (AG), réalisant ainsi une double cellule UUPROM.

5. Circuit selon la revendication 4, caractérisé en ce que la double cellule UUPROM comporte un axe de symétrie (M) qui la sépare en deux plans de structures symétriques, chacun comportant une cellule ($C_1$, $C_2$).

6. Circuit selon l'une quelconque des revendications précédentes, avec une connexion enterrée comportant un caisson et à cheval sur ce caisson et le substrat, deux diffusions en vis à vis, caractérisé en ce que la longueur (L) des deux diffusions en regard, est supérieure à la distance (1) qui les sépare, cette longueur étant celle des côtés des deux diffusions en vis à vis, parallèles et d'identique longueur.

EP 0 433 174 B1

**Patentansprüche**

1. In MOS-Technologie und auf Basis eines einen ersten Dotierungstyp (P) aufweisenden Halbleiters verwirklichte integrierte Schaltung mit mindestens einer ein Schwebendgate ($GF_1$) aufweisenden Speicherzelle ($C_1$) mit einer Source ($S_1$), einem Drain ($D_1$) und einem Steuergate ($GC_1$), deren UV-Schutzmaske (Mm) aus Metall die obere Fläche zudeckt und als Metallschenkel ausgebildete Verankerungsstellen (Rm) am Substrathalbleiter aufweist, dadurch gekennzeichnet, daß das Steuergate ($GC_1$) durch eine Diffusion mit einer Dotierung des zweiten Typs ($N^+$) verwirklicht ist, und daß die Verankerungsstellen einen geschlossenen Metallring (Am) bilden, der an einem Diffusionsring (Ad) verankert ist, der eine Dotierung des gleichen Typs, die jedoch intensiver ($P^+$) als die des Substrats ist, aufweist, wobei der Ring (Ad) breiter als der Metallring (Am) ist, der die Schwebendgatespeicherzelle ($C_1$) von UV-Strahlen innerhalb einer inneren Zone (1) des Metallrings (Am) vollständig isoliert, wobei das Drain ($D_1$), die Source ($S_1$) und das Steuergate ($GC_1$) mit dem Außenteil des Metallrings (Am) über tiefliegende Verbindungen verbunden sind.

2. Integrierte Schaltung nach Anspruch 1, dadurch gekennzeichnet, daß die Metallschenkel (Rm) der Metallmaske (Mm) am Rand der Metallmaske (Mm) nicht verwirklicht sind.

3. Integrierte Schaltung nach Anspruch 1 oder Anspruch 2, dadurch gekennzeichnet, daß eine Auswahlschaltung ($TS_1$) der UUPROM-Zelle außerhalb des Rings (Am) angeordnet ist.

4. Integrierte Schaltung nach Anspruch 2 oder Anspruch 3, dadurch gekennzeichnet, daß die zwei Schwebendgatespeicherzellen ($C_1$ und $C_2$) innerhalb des gleichen Metallrings angeordnet sind, wobei deren jede einen Auswahltransistor ($TS_1$ und $TS_2$) besitzt und als gemeinsame zwischen ihnen erstreckende Verbindung lediglich ihre Sources ($S_1$ und $S_2$) aufweist, die mit dem gleichen Signal der gesteuerten Masse (AG) beaufschlagt werden, so daß eine doppelte UUPROM-Zelle verwirklicht wird.

5. Integrierte Schaltung nach Anspruch 4, dadurch gekennzeichnet, daß die doppelte UUPROM-Zelle eine Symmetrieachse (M) aufweist, die sie in zwei Ebenen mit symmetrischem Aufbau trennt, die jeweils eine Zelle ($C_1$ und $C_2$) aufweist.

6. Integrierte Schaltung nach einem der vorhergehenden Ansprüche mit einer tiefliegenden Verbindung mit einer Insel, wobei die Verbindung zwei sich gegenüberliegende Diffusionen aufweist, die die Insel und das Substrat überspannen, dadurch gekennzeichnet, daß die Länge (L) der zwei sich gegenüberliegenden Diffusionen die sie trennende Entfernung (1) übersteigt, wobei diese Länge der Länge der Seiten der zwei sich gegenüberliegenden, parallelen und gleichlangen Diffusionen entspricht.

**Claims**

1. An integrated circuit produced using MOS technology from a semiconductor having a first type of doping (P), comprising at least one memory cell ($C_1$) having a floating gate ($GF_1$), a source ($S_1$), a drain ($D_1$) and a control gate ($GC_1$) and being protected from ultraviolet rays by a metal mask (Mm) which covers its upper surface, this mask having fixing locations on the semiconductor substrate formed by downward metal projections (Rm) from the metal mask (Mm), characterized in that the control gate ($GC_1$) is formed by diffusion of a second type of doping ($N^+$), and in that the fixing locations form a continuous ring of metal (Am) fixed to a ring (Ad) consisting of a diffusion of the same type but more highly doped ($P^+$) than the substrate (P) and wider than the metal ring (Am), this metal ring completely isolating the floating gate memory cell ($C_1$) from ultraviolet rays in a region (1) inside the metal ring (Am), the drain ($D_1$) the source ($S_1$) and the control gate ($GC_1$) being connected to the outside of the metal ring (Am) by buried connections.

2. An integrated circuit as claimed in claim 1, characterized in that the downward metal projections (Rm) from the metal mask (Mm) are not formed at the edge of the metal mask (Mm).

3. An integrated circuit as claimed in claim 1 or claim 2, characterized in that a circuit ($TS_1$) for selection of the UUPROM cell is located outside the metal ring (Am).

4. A circuit as claimed in either one of claims 2 or 3, characterized in that two floating gate memory cells ($C_1$, $C_2$) are inside the same metal ring each having their own selection transistor ($TS_1$, $TS_2$) and having only their sources ($S_1$, $S_2$) connected together in common, the latter being connected to a common array ground signal (AG) thus forming a double UUPROM cell.

5. A circuit as claimed in claim 4, characterized in that the double UUPROM cell comprises an axis of symmetry (M) which separates it into two symmetrical structural layouts each comprising one cell ($C_1$, $C_2$).

6. A circuit as claimed in any one of the preceding claims which has a buried connection comprising an island and, bridging this island and the substrate, two facing diffusions, characterized in that the length (L) of the two facing diffusions is greater than the distance (1) which separates them, the length in question being that of the sides of the two parallel, facing diffusions of identical length.

9

# FIG_1

# FIG_3

FIG_2

## FIG_4-a

Mm

A →    Rm    Am    GF1    200    Am    ← A'
300    0

Ad    P+    N+    N+    Z₃    AD    P+

GC₁    P

## FIG_4-b

BL₁    Mm

LM₁    Rm    Am

B →    Z4    Ad    B'
Dt₁    St₁    N+    Ca₂    11    Z₂    P

## FIG_4-c

CG$_1$    Mm

Rm    GF$_1$    300

C →    ~Am    C'

Ad    Z5

N    P+    N+

Ca$_4$    GC$_1$

P

## FIG_4-d

Mm

Rm    Am    GF$_1$    100

200    D'

D →    Z$_3$    0    D$_1$    S$_1$

Ad    P+    N+    N+    N+

D$_1$    S$_1$

P